# EUROPÄISCHE PATENTSCHRIFT

(11) **EP 0 880 606 B1**
(45) Veröffentlichungstag und Bekanntmachung des Hinweises auf die Patenterteilung: **05.01.2000**
(21) Anmeldenummer: 97914143.9
(22) Anmeldetag: 07.02.1997
(51) Int. Cl.: C23C 14/54, C23C 14/24

(54) **VERFAHREN UND EINRICHTUNG ZUR REGELUNG EINES VAKUUMBEDAMPFUNGSPROZESSES**
METHOD AND DEVICE FOR CONTROL OF A VACUUM VAPORIZATION PROCESS
PROCEDE ET DISPOSITIF POUR LA REGULATION D'UN PROCESSUS DE METALLISATION SOUS VIDE

(30) Priorität: 14.02.1996 DE 19605335
(43) Veröffentlichungstag der Anmeldung: 02.12.1998
(73) Patentinhaber: FRAUNHOFER-GESELLSCHAFT ZUR FÖRDERUNG DER ANGEWANDTEN FORSCHUNG E.V., 80636 München (DE)
(72) Erfinder: GOEDICKE, Klaus, Dipl.-Phys., 01307 Dresden (DE); SCHEFFEL, Bert, Dipl.-Phys., 01324 Dresden (DE); METZNER, Christoph, Dipl.-Phys., 01474 Pappritz (DE)
(86) Internationale Anmeldenummer: DE9700267
(87) Internationale Veröffentlichungsnummer: WO9730187

(56) Entgegenhaltungen:
- EP-A- 0 028 514
- PATENT ABSTRACTS OF JAPAN vol. 007, no. 011 (C-145), 18.Januar 1983 & JP 57 169088 A (OLYMPUS KOGAKU KOGYO KK), 18.Oktober 1982,
- PATENT ABSTRACTS OF JAPAN vol. 016, no. 362 (C-0971), 5.August 1992 & JP 04 116166 A (HITACHI LTD), 16.April 1992,
- PATENT ABSTRACTS OF JAPAN vol. 017, no. 124 (C-1035), 16.März 1993 & JP 04 301071 A (KOBE STEEL LTD), 23.Oktober 1992,

## Beschreibung

Die Erfindung betrifft ein Verfahren zur Regelung eines Vakuumbedampfungsprozesses. Nach dem Verfahren werden insbesondere Werkzeuge und plattenförmige Substrate, z.B. Spiegel und Glasscheiben, mit Funktionsschichten bedampft.

Beim Bedampfen werden hohe Anforderungen hinsichtlich der Gleichmäßigkeit der Schichtdicke, der Stabilität der Bedampfungsrate über lange Zeiträume und der Zusammensetzung des Schichtmaterials gestellt. Diese Anforderungen können besonders bei der Bedampfung von großflächigen Substraten nur dann erfüllt werden, wenn die Parameter des Bedampfungsprozesses konstant gehalten werden. Das setzt voraus, daß die Parameter des Verdampfens, insbesondere die Verdampfungsgeschwindigkeit, der Füllstand eines Verdampfertiegels und die Richtungsverteilung des Dampfes konstantgehalten bzw. angepaßt werden. Das zu verdampfende Material befindet sich in einem Verdampfer. Das kann z.B. ein Verdampfertiegel, in dem das Material - das Verdampfungsgut - aufgeschmolzen wird, sein. Diese Verdampfer sind waagerecht angeordnet. Es werden auch Sublimationsverdampfer eingesetzt, bei denen das Verdampfungsgut in einer Halterung befestigt ist, und durch Energiezufuhr, z.B. Elektronenstrahlen, Widerstandsheizung, aus der festen Phase verdampft wird. Diese Verdampfer können sowohl horizontal und vertikal als auch schräg angeordnet sein.

Es ist bekannt, die Bedampfungsrate an einem oder mehreren Orten in Substratnähe zu messen. Es gibt eine Vielzahl von Verfahren zur Bestimmung der Bedampfungsrate, wie z.B. die Schichtdickenmessung mittels Schwingquarz oder Mikrowaage in Substratnähe (G. Kienel: Vakuumbeschichtung Band 3 - Anlagenautomatisierung, VDI-Verlag, Düsseldorf, 1994, S. 25 ff, S. 35 ff, S. 40 ff). Nach diesen Verfahren zur Schichtdickenmessung wird die Bedampfungsrate ermittelt. Mit dem gewonnenen Signal wird über einen Regelkreis die Verdampfungsgeschwindigkeit und damit der Bedampfungsprozeß geregelt. Der wesentlichste Nachteil dieser Verfahren besteht in der Meßanordnung. Die Sensoren müssen im Dampfraum angeordnet sein und unterliegen damit einer so hohen Dampf- und Wärmebelastung, daß sie nach relativ kurzer Zeit ausgetauscht werden müssen. Dadurch ist eine häufige Prozeßunterbrechung nötig und ein Langzeitbetrieb kaum möglich. Aus diesem Grund sind die Verfahren nur für kleine Bedampfungsraten geeignet. Desweiteren wird nur ein kleiner Teil des Dampfstromes gemessen, von dem aus auf den gesamten Dampfstrom g eschlossen wird, der das Substrat erreicht. Bei großflächigen Substraten wirkt das besonders nachteilig, da die Sensoren, um das Substrat nicht abzuschatten, in einem anderen Abstand und Winkel zum Verdampfer als das Substrat angeordnet sind und deshalb die Dampfstromdichte zum Sensor eine andere Größe hat, als die Dampfstromdichte zum Substrat. Dadurch ergeben sich Fehler.
Zur Vermeidung dieser Fehler sind andere Meßverfahren zur Prozeßregelung bekannt, die in einem Zusammenhang zum Dampfstrom zwischen Verdampfer und Substrat stehen. Dazu sind die Auswertung der emittierten Plasmastrahlung (DD 239 810 A1), Bestimmung der Absorption von Licht oder Laserstrahlen im Dampf (Gogol, C.A., Reagan, S.H., J. Vac. Sci. Technol. A1 (2), Apr/Jun. 1983, S. 252 - 256) oder die Auswertung der lonisierung des Dampfes durch Elektronenbeschuß (Hegner, F.: Anwendung der Elektronen-Emissionsspektroskopie für das ratengeregelte Aufdampfen von Legierungen, Vak. Techn. 29, 2 (1980), S. 45 - 49) bekannt. Bei diesen Verfahren liegen die Sensoren nicht unmittelbar im Dampfstrom, sondern sind seitlich versetzt zum Dampfstrom angeordnet. Auch diese Verfahren sind indirekte Meßverfahren, bei denen der wesentliche Nachteil darin besteht, daß die Meßgrößen außer von der Dampfdichte in starkem Maße von weiteren Faktoren, wie z.B. der Art des Verdampfungsgutes, Anregung und lonisierung des Dampfes und der Dampfgeschwindigkeit, abhängen. Diese Meßanordnungen müssen deshalb für jedes Verdampfungsgut neu kalibriert werden, was sehr aufwendig ist. Ein weiterer Nachteil ist, daß die Sensoren im Dampfraum angeordnet sein müssen und somit wiederum einer allmählichen Beschichtung unterliegen. Dadurch sind ebenfalls Prozeßunterbrechungen für den Wechsel der Sensoren erforderlich, was ungünstig für einen Langzeitbetrieb ist.

Es ist allgemein bekannt, die Verdampfungsgeschwindigkeit als zeitlichen Mittelwert durch Wägung des Verdampfungsgutes zu bestimmen, indem der Bedampfungsprozeß in größeren zeitlichen Abständen unterbrochen wird. Dieses Verfahren ist jedoch für den industriellen Einsatz ungeeignet, da die Verdampfungsgeschwindigkeit nur über große zeitliche Abstände gemittelt wird und somit für eine ständige Regelung des Bedampfungsprozesses nicht zur Verfügung steht, bzw. der Bedampfungsprozeß für das Wägen ständig unterbrochen werden müßte.

Weiterhin ist ein Verfahren zur Füllstandsüberwachung von Verdampfertiegeln mittels Licht- oder Laserstrahlen bekannt. Dabei wird ein Strahl auf der Oberfläche des Verdampfungsmaterials reflektiert und aus dem Strahlengang auf die Füllhöhe des Verdampfertiegels geschlossen (DE 38 27 920 A1). Dieses Verfahren hat den Nachteil, daß durch mögliche Wellenbewegungen der Oberfläche des Verdampfungsmaterials der Strahlengang gestört wird. Das Verfahren hat außerdem den Mangel, daß der Strahl, indem er durch die Bereiche höchster Dampfdichte geführt werden muß, einer Streuung und Absorption unterliegt, was zu einer Verfälschung des Meßergebnisses führt. Aus diesem Grund ist dieses Verfahren nur bedingt geeignet, einen Bedampfungsprozeß so zu regeln, um damit den hohen Anforderungen an die Stabilität der Bedampfungsrate und der exakten Zusammensetzung der aufgedampften Schicht gerecht zu werden.

Es ist ein Verfahren zum Aufdampfen von lichtempfindlichem Material bekannt (EP 0 028 514 A1). Bei diesem Verfahren wird der Verdampfertiegel gewogen, um daraus die Verdampfungsrate des lichtempfindlichen Materials zu ermitteln. In Abhängigkeit von der Gewichtsänderung und der Verdampfertiegeltemperatur wird die in den Verdampfertiegel einzubringende Energie geregelt.

Der Erfindung liegt die Aufgabe zugrunde, ein Verfahren zu schaffen, das es gestattet, einen Vakuumbedampfungsprozeß an eine vorgegebene Bedampfungstechnologie anzupassen, indem das Verdampfen überwacht und seine Parameter so beeinflußt werden, daß einzelne, platten- oder bandförmige Substrate reaktiv oder nichtreaktiv mit hoher Schichtqualität bedampft werden, wobei insbesondere bei großflächigen Substraten gleichmäßige Schichtdicken mit einer vorgegebenen Schichtzusammensetzung erzielt werden. Die Verdampfer, die aus der festen Phase das Material verdampfen, sollen in beliebiger Lage anzuordnen sein. Der Bedampfungsprozeß soll über einen langen Zeitraum einfach und zuverlässig durchführbar sein.

Die Aufgabe wird nach den Merkmalen des Patentanspruchs 1 gelöst. Weitere vorteilhafte Ausgestaltungen sind in den Ansprüchen 2 bis 8 beschrieben.

Überraschenderweise wurde gefunden, die Rückstoßkraft des Dampfes auf das Verdampfungsgut als Meßgröße zu verwenden. Sie ist für die Regelung von Bedampfungsprozessen gut geeignet, obwohl sie bisher noch nicht als Meßgröße bei Bedampfungsprozessen verwendet wurde.

Mit dieser Meßgröße ist es möglich, über einen an sich bekannten Regelkreis Parameter des Verdampfungsprozesses - insbesondere die Verdampfungsgeschwindigkeit, den Füllstand eines Verdampfertiegels und die Richtungsverteilung des Dampfes - zu beeinflussen, denn die Eigenschaften der auf die Substrate aufgedampften Schichten werden im wesentlichen durch diese Parameter bestimmt.
Die Rückstoßkraft des Dampfes auf das Verdampfungsgut entsteht dadurch, daß die Dampfteilchen die Oberfläche des Verdampfungsgutes gerichtet verlassen und mit hohen Teilchengeschwindigkeiten emittiert werden. Die Rückstoßkraft ist gleich dem Produkt aus der Verdampfungsgeschwindigkeit des Verdampfungsmaterials, d.h. der je Zeiteinheit verdampften Masse und der mittleren, zur dampfabgebenden Oberfläche normalen Geschwindigkeitskomponente der verdampfenden Teilchen. Diese mittlere, normale Geschwindigkeitskomponente ist wiederum das Integral des Produkts aus der Richtungsverteilungsfunktion und der mittleren thermischen Geschwindigkeit der emittierten Teilchen über den gesamten Raumwinkelbereich. Die Richtungsverteilung der emittierten Teilchen entspricht dabei oft einer Kosinusverteilung mit einem Maximum in der Normalen zur dampfabgebenden Oberfläche, sie kann jedoch besonders durch die Wirkung der Rückstoßkraft auf die dampfabgebende Oberfläche des aufgeschmolzenen Verdampfungsgutes (Badeinbeulung) zugunsten einer stärkeren Bündelung des Dampfes verändert sein. Der Rückstoßkraft ist bei Bedampfungsprozessen mit Teilchen- oder Strahlungsbeschuß noch die Stoßkraft der auf das Verdampfungsgut auftreffenden Teilchen oder Lichtquanten überlagert. Diese kann prinzipiell berücksichtigt werden, ist aber insbesondere bei Elektronenbeschuß vernachlässigbar klein.

Die wesentlichen Vorteile der Erfindung sind, daß die zu überwachende Größe der Rückstoßkraft nicht durch andere Einflüsse, z.B. die Anregung des Dampfes, verfälscht wird, daß die Rückstoßkraft als mechanische Größe meßtechnisch einfach zugänglich ist, daß über diese Meßgröße der gesamte Dampfstrom erfaßt und nicht nur ein Bereich zur Charakterisierung des Dampfstromes herangezogen wird. Dazu ist der Verdampfer mittels bekannter Kraftmeßzellen in der Vakuumkammer befestigt. Alle Versorgungsleitungen werden so angeschlossen, daß sie das Meßergebnis nicht beeinflussen bzw. die dadurch entstehenden Fehler eliminierbar sind. Die als Sensor arbeitenden Kraftmeßzellen sind vorzugsweise elastische Elemente mit aufgebrachten Dehnmeßstreifen.

Bei Bedampfungsprozessen mit Gaseinlaß wird die dampfabgebende Oberfläche des Verdampfungsgutes teilweise mit rückgestreutem Dampf beaufschlagt und gegebenenfalls kontaminiert, insbesondere, wenn ein reaktives Gas eingelassen wird. Infolgedessen kommt es zu einer Veränderung der Verdampfungsgeschwindigkeit und als Ergebnis davon z.B. zu einer Veränderung der Zusammensetzung des Schichtmaterials. Nach dem erfindungsgemäßen Verfahren werden Substrate gleichmäßig mit einer vorgegebenen Schichtzusammensetzung bedampft, indem die gemessene Rückstoßkraft durch Regelung des Gasflusses in die Vakuumkammer auf einen vorgegebenen Sollwert einstellt wird. Dazu sind bekannte Kraftmeßzellen auf der dampfabgewandten Seite des Verdampfers angeordnet und damit vom Dampfstrom abgeschirmt. Dadurch wird ihre Funktion vom Bedampfungsprozeß nicht beeinflußt. Somit wird eine hohe Zuverlässigkeit gewährleistet, und das Verfahren ist auch im Langzeitbetrieb einfach und betriebssicher durchführbar.

Die Regelung eines Bedampfungsprozesses wird wie folgt durchgeführt. Die Rückstoßkraft des auf die Substrate gerichteten Dampfstromes, die auf den Verdampfer wirkt, wird mit den Kraftmeßzellen bestimmt. Das gewonnene Signal wird zunächst verstärkt und einer Filterung unterzogen. Diese Filterung wird analog mit einem elektronischen Tiefpaß oder aber nach Umwandlung in digitale Daten durch Digitalfilter durchgeführt. Das gefilterte Signal wird einem bekannten Regelkreis zugeführt, der mindestens einen der Parameter, die den Bedampfungsprozeß beeinflussen, regelt bzw. steuert.
Die Rückstoßkraft kann in jeder Einbaulage des jeweiligen Verdampfers ermittelt werden. Erfolgt das Verdampfen in horizontaler Richtung, z.B. bei Sublimationsverdampfern mit bevorzugt horizontaler Dampfausbreitungsrichtung, wird die Rückstoßkraft in horizontaler Richtung gemessen. Die Messung der Rückstoßkraft kann kontinuierlich oder in beliebigen Zeitabständen erfolgen.

Beim Verdampfen in vertikaler Richtung wird die Rückstoßkraft in vertikaler Richtung gemessen. Beim Verdampfen in schräger Richtung wird die Rückstoßkraft durch Messen in horizontaler und vertikaler Richtung ermittelt. In beiden Fällen ist der Rückstoßkraft außerdem noch die Gewichtskraft von Verdampfungsgut und Verdampfertiegel überlagert. Da sich das Gewicht des Verdampfungsgutes im Verlauf des Verdampfens verändert, muß in diesem Fall eine meßtechnische Trennung von Gewichts- und Rückstoßkraft erfolgen. Diese meßtechnische Trennung wird erfindungsgemäß dadurch gelöst, daß der die Verdampfungsgeschwindigkeit bestimmende Parameter in seiner Größe so schnell verändert wird, daß die Änderungsgeschwindigkeit der Rückstoßkraft groß gegen die Änderungsgeschwindigkeit des Gewichts des Verdampfungsgutes ist. Das kann vorteilhafterweise durch kurzes Aus- und Wiedereinschalten oder kurzzeitige Reduzierung der Energiezufuhr zum Verdampfungsmaterial erfolgen. Die Kraftänderung während der Einschalt- bzw. Ausschaltphase wird als Maß für die Rückstoßkraft des Dampfstromes erfaßt.
Beim Verdampfen in vertikaler oder schräger Richtung wird die Rückstoßkraft bei durchlaufenden Substraten in der Zeit ermittelt, in der sich kein Substrat über dem Verdampfer befindet. Beim Bedampfen von bandförmigem Substrat, z.B. Stahlband, Kunststoffolie, wird die Rückstoßkraft am Anfang und am Ende des Bedampfungsprozesses ermittelt oder in gleichbleibenden Zeitabständen, wobei die aufgedampfte Schicht in diesen Meßbereichen beeinflußt wird.

Mit diesem Verfahren lassen sich eine Vielzahl von Parametern regeln, um das Verdampfen zu kontrollieren und damit in direkter Weise Einfluß auf den Bedampfungsprozeß zu nehmen.

Es ist auch möglich, mit einem an sich bekannten Regelkreis, mit der Rückstoßkraft als Regelgröße, die elektrische Leistung zum Heizen des Verdampfungsgutes zu regeln, da sich diese elektrische Leistung unmittelbar auf die Verdampfungsgeschwindigkeit und die mittlere thermische Geschwindigkeit der Dampfteilchen auswirkt und somit den Bedampfungsprozeß bestimmt.

Eine weitere vorteilhafte Ausgestaltung besteht darin, bei Bedampfungsprozessen, bei denen die Energiezufuhr örtlich und/oder zeitlich gesteuert erfolgt, wie z.B. beim Elektronenstrahlverdampfen mit Strahlablenkung, das aus der Rückstoßkraft gewonnene Signal zur Beeinflussung dieser Ablenkparameter und/oder der Strahlfokussierung in bekannter Weise zu nutzen.

Sind die Richtungsverteilung und die mittlere thermische Geschwindigkeit der Dampfteilchen bekannt oder bleiben ihre Größen im Bedampfungsprozeß nahezu konstant, ist es möglich den Bedampfungsprozeß mit Hilfe des aus der Rückstoßkraft gewonnenen Signals so zu regeln, daß die Verdampfungsgeschwindigkeit über einen langen Zeitraum konstant gehalten oder entsprechend der Bedampfungsaufgabe gezielt verändert wird.

Eine weitere vorteilhafte Ausgestaltung des Verfahrens zur Regelung von Bedampfungsprozessen besteht darin, daß bei Verdampfertiegeln mit kontinuierlich arbeitenden Nachfülleinrichtungen für das Verdampfungsgut über das aus der Rückstoßkraft gewonnene Signal, das der Verdampfungsgeschwindigkeit proportional ist, den Nachschub so zu regeln, daß die Menge des Verdampfungsgutes oder die Füllhöhe im Verdampfertiegel konstant bleibt. Dadurch wird eine Langzeitstabilität der Verdampfungsrate erreicht, da diese auch von der Füllhöhe abhängt.

Bei Verdampfertiegeln ohne Nachfülleinrichtung läßt sich aus dem aus der Rückstoßkraft gewonnenen Signal der Verbrauch von Verdampfungsgut oder die momentane Füllhöhe des Verdampfertiegels ermitteln. Die so gewonnenen Parameter werden wiederum zur Regelung des Bedampfungsprozesses genutzt, indem zum einen die Strahlfokussierung und/oder die Ablenkparameter geregelt werden, um beispielsweise eine Veränderung der Bedampfungsrate zu vermeiden. Zum anderen wird der Zeitpunkt und die Menge für das Nachfüllen von Verdampfungsgut bestimmt.

Desweiteren kann die Richtungsverteilung des Dampfes konstant gehalten werden, wenn die mittlere thermische Geschwindigkeit der Dampfteilchen bekannt ist und die Verdampfungsgeschwindigkeit experimentell bestimmt wurde. In diesem Fall ist die Rückstoßkraft ein Maß für die Richtungsverteilung der emittierten Dampfteilchen. Die elektrische Leistung zum Erhitzen des Verdampfungsgutes bzw. die Verteilung der Leistungsdichte auf der Oberfläche des Verdampfungsguts werden so geregelt, daß die Rückstoßkraft einen bestimmten Wert annimmt.

Es ist auch möglich, bei Bedampfungsprozessen, bei denen die Energiezufuhr örtlich bzw. zeitlich gesteuert erfolgt, wie z.B. beim Elektronenstrahlverdampfen mit Strahlablenkung, den Ort der Verdampfungszone auf dem Verdampfungsgut zu bestimmen. Die Rückstoßkraft wird an zwei verschiedenen Stellen des Verdampfers, vorzugsweise an den schmalen Seiten bei langgestreckten Verdampfern, ermittelt. Erfolgt die Verdampfung von einer Zone im Mittelpunkt zwischen den Kraftmeßzellen, wird die Rückstoßkraft auf beide Kraftmeßzellen in gleicher Größe übertragen. Erfolgt die Verdampfung außermittig, wird sich die Rückstoßkraft zu ungleichen Teilen auf die Kraftmeßzellen übertragen. Erfindungsgemäß wird aus der Auswertung der beiden Signale der Rückstoßkraft auf den Ort der Verdampfungszone geschlossen. Der Ort der Verdampfungszone wird dann über einen an sich bekannten Regelkreis korrigiert.

Diese Verfahrensvariante ist auch geeignet, wenn mehrere Verdampfungszonen auf dem Verdampfungsgut beheizt werden. Dazu wird zuerst die Rückstoßkraft, die von allen Verdampfungszonen ausgeht, bestimmt. Danach wird die Rückstoßkraft, die von einer einzelnen der Verdampfungszonen ausgeht, dadurch bestimmt, daß die Energiezufuhr nur zu di eser Verdampfungszone kurzzeitig unterbrochen wird, die Energiezufuhr zu allen anderen Verdampfungszonen jedoch in unveränderter Stärke aufrechterhalten wird. Die Auswertung der Änderung der Rückstoßkraft an den Kraftmeßzellen wird jeweils wie oben beschrieben durchgeführt. Das gewonnene Signal wird in einem Regelkreis dazu benutzt, die Verdampfungsgeschwindigkeit, die von dieser Verdampfungszone ausgeht, auf einen bestimmten Sollwert zu regeln.

Bereits vorhandene Verdampfungseinrichtungen lassen sich ohne großen Aufwand nachr üsten, indem die Verdampfer nicht mehr direkt mit der Vakuumkammer verbunden sind, sondern Kraftmeßzellen zwischen Verdampfer und Vakuumkammer angeordnet sind. Desweiteren ist ein herkömmlicher Regelkreis notwendig, der im einfachsten Fall aus einem Filter und einem Regler besteht, mit dem das Signal verarbeitet und die entsprechenden Parameter zur Regelung des Bedampfungsprozesses angesteuert werden.

An einem Ausführungsbeispiel wird die Erfindung näher beschrieben. In den zugehörigen Zeichnungen zeigen:
- Fig. 1:: einen Schnitt durch eine Einrichtung zur Durchführung des Verfahrens mit einer Elektronenkanone und einem horizontal angeordneten Verdampfertiegel,
- Fig. 2:: ein Diagramm der Kraft und der elektrischen Leistung, in Abhängigkeit von der Zeit, beim Elektronenstrahlverdampfen.

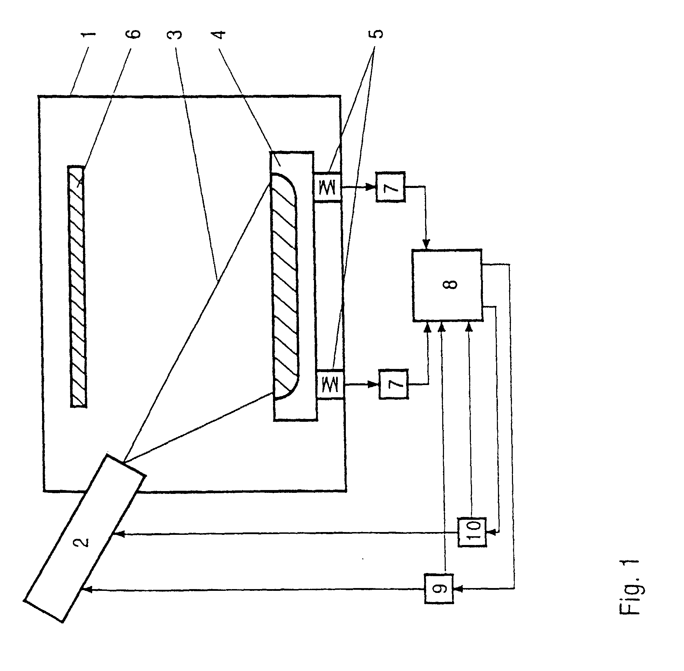

In Fig. 1 ist an einer Seite einer Vakuumkammer 1 eine Elektronenkanone 2 vom Axialtyp angeordnet, deren Elektronenstrahl 3 einen mit Titan gefüllten Verdampfertiegel 4 programmiert beaufschlagt. Der Verdampfertiegel 4 ist mittels Kraftmeßzellen 5, vorzugsweise elastische Elemente mit aufgebrachten Dehnmeßstreifen, in der Vakuumkammer 1 befestigt. Über dem Verdampfertiegel 4 ist ein zu bedampfendes Substrat 6 angeordnet. Die den Kraftmeßzellen 5 nachgeschalteten Filter 7 bereiten die Signale der mit den Kraftmeßzellen 5 gemessenen Kräften auf. Die Ausgangssignale der Filter 7 werden einem Regler 8 zugeführt. Dieser wertet die Signale nur in den Meßzeiten aus, die durch Signale eines Leistungssteller 9 und einer Ablenksteuerung 10 vorgegeben werden, nämlich in den Meßzeiten, bevor oder nachdem eine sprunghafte Änderung der Elektronenstrahlleistung erfolgt.

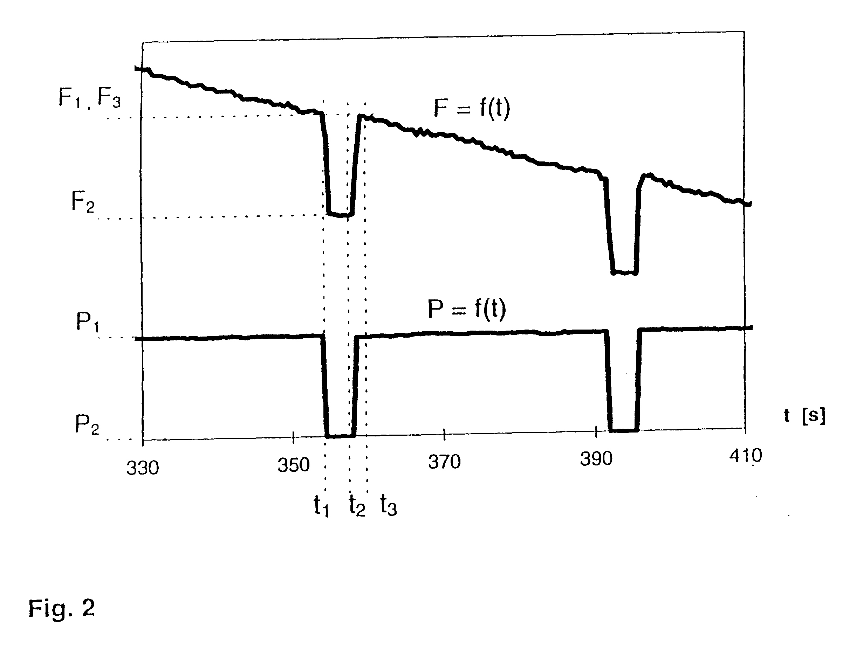

Fig. 2 zeigt, zu welchen Zeiten die Signale der Kraftmeßzellen 5 dem Regler 8 zugeführt werden. Die Elektronenstrahlleistung P und die Kraft F als Summe der Signale der Kraftmeßzellen 5 sind als Funktion über der Zeit t dargestellt. Zunächst erfolgt die Verdampfung mit der Elektronenstrahlleistung P₁. Zu der Zeit t₁ wird die Kraft F₁ gemessen, welche sich aus der Rückstoßkraft des verdampfenden Titans und der Gewichtskraft des schmelzflüssigen Titans und des Verdampfertiegels 4 zusammensetzt. Anschließend wird die Elektronenstrahlleistung P ohne Verzögerung von P₁ auf P₂ = 0 geschaltet. Zur Zeit t₂ (t₂>t₁), wenn kein Titan mehr verdampft, wird die Kraft F₂ gemessen. Die Kraft F₂ entspricht dann der Gewichtskraft. Anschließend wird die Elektronenstrahlleistung P ohne Verzögerung wieder auf den Wert P₁ geschaltet. Zu der Zeit t₃(t₃>t₂) wird die Kraft F₃ gemessen. Diese Kraft F₃ setzt sich wieder aus der Rückstoßkraft des verdampfenden Titans und der Gewichtskraft des schmelzflüssigen Titans und des Verdampfertiegels 4 zusammen.
Im Regler 8 wird aus der Differenz zwischen den zum Zeitpunkt t₁ und t₂ gemessenen Kräften F₁ und F₂ die Rückstoßkraft ermittelt. Der Regler 8 vergleicht die ermittelte Rückstoßkraft mit vorgegebenen Sollwerten. Die Rückstoßkraft aus der Differenz zwischen den zum Zeitpunkt t₃ und t₂ gemessenen Kräften F₃ und F₂ wird für Kontrollzwecke ermittelt. Bei einer Abweichung der Rückstoßkraft von einem Sollwert wird der Sollwert für den Leistungssteller 9 und/oder die Ablenksteuerung 10 der Elektronenkanone 2 so nachgeführt, daß die Abweichung der Rückstoßkraft vom Sollwert minimiert wird.

Abweichend von diesem Ausführungsbeispiel werden bei schräger Anordnung des Verdampfers die Kräfte in horizontaler und vertikaler Richtung von den Kraftmeßzellen gemessen. Die in horzintaler Richtung gemessene Kraft ist eine Komponente der resultierenden Rückstoßkraft. Bei den in vertikaler Richtung gemessenen Kräften wird die vertikal wirkende Komponente der Rückstoßkraft wie im Ausführungsbeispiel ermittelt. Anschließend wird im Regler 8 die resultierende Rückstoßkraft ermittelt, die wie oben beschrieben zur Regelung verwendet wird.
Bei vertikaler Anordnung eines Verdampfers wirkt die Rückstoßkraft in horizontaler Richtung. Dieser Rückstoßkraft ist keine weitere Kraft überlagert. Es ist damit keine meßtechnische Trennung von Kräften erforderlich. Die Rückstoßkraft wird ständig gemessen und wie oben beschrieben zur Regelung verwendet.

## Patentansprüche

1. Verfahren zur Regelung eines Vakuumbedampfungsprozesses, mit dem Substrate durch den aus mindestens einem, vorzugsweise durch Elektronenstrahlen geheizten Verdampfer, der in einer Vakuumkammer angeordnet ist, bedampft werden, und mindestens ein Prozeßparameter über einen Regelkreis den Bedampfungsbedingungen angepaßt wird, **dadurch gekennzeichnet,** daß die Rückstoßkraft des auf die zu bedampfenden Substrate gerichteten Dampfstroms, die senkrecht zur Oberfläche des Verdampfungsgutes wirkt, an mindestens einer Stelle ermittelt wird, indem die auf die Befestigung des Verdampfers wirkende Kraft gemessen wird, daß diese gewonnene Meßgröße als Signal erfaßt wird und daß dieses Signal als Regelgröße dem Regelkreis zugeführt wird, der die Prozeßparameter regelt.

2. Verfahren nach Anspruch 1, **dadurch gekennzeichnet,** daß bei von der vertikalen Lage abweichend in der Vakuumkammer angeordnetem Verdampfer die Rückstoßkraft derart ermittelt wird, daß die auf den Verdampfer wirkende Gewichts- und Rückstoßkraft als Summe gemessen werden, daß aus der Summe dieser beiden Kräfte die Rückstoßkraft meßtechnisch getrennt wird, indem mindestens ein die Verdampfungsgeschwindigkeit bestimmender Prozeßparameter in seiner Größe so schnell verändert wird, daß die Änderungsgeschwindigkeit der Rückstoßkraft groß gegen die Änderungsgeschwindigkeit der Gewichtskraft ist, und daß durch Differenzbildung der Summe dieser Kräfte vor der Änderung und der Summe dieser Kräfte nach der Änderung der die Verdampfungsgeschwindigkeit bestimmenden Prozeßparameter die Rückstoßkraft ermittelt wird.

3. Verfahren nach Anspruch 2, **dadurch gekennzeichnet,** daß die Änderung eines die Verdampfungsgeschwindigkeit bestimmenden Prozeßparameters derart erfolgt, daß die Energiezufuhr zum Verdampfungsgut kurzzeitig unterbrochen oder reduziert wird, oder die Leistungsdichte der Energie auf dem Verdampfungsgut reduziert wird.

4. Verfahren nach Anspruch 1 bis 3, **dadurch gekennzeichnet,** daß mit dem aus der Rückstoßkraft gewonnenen Signal die Regelung der Energiezufuhr zum Verdampfungsgut derart erfolgt, daß die Rückstoßkraft konstant gehalten wird.

5. Verfahren nach Anspruch 1 bis 4, **dadurch gekennzeichnet,** daß bei der Verwendung von Verdampfern mit Nachfülleinrichtungen für Verdampfungsgut mit dem aus der Rückstoßkraft gewonnenen Signal die Füllhöhe des Verdampfers durch Regelung der Füllmenge konstant gehalten wird.

6. Verfahren nach Anspruch 1 bis 5, **dadurch gekennzeichnet,** daß mit dem aus der Rückstoßkraft gewonnenen Signal zur Regelung der örtlichen und/oder zeitlichen Verteilung der Leistungsdichte auf dem Verdampfungsgut die Rückstoßkraft auf einen vorgegebenen Sollwert geregelt wird.

7. Verfahren nach Anspruch 1 bis 6, **dadurch gekennzeichnet,** daß die Rückstoßkraft bei großflächigen Verdampfern an mindestens zwei Stellen ermittelt wird, und die örtliche und/oder zeitliche Verteilung der Leistungsdichte auf dem Verdampfungsgut so geregelt wird, daß die einzelnen Rückstoßkräfte auf vorgegebene Sollwerte geregelt werden.

8. Verfahren nach Anspruch 1 bis 7, **dadurch gekennzeichnet,** daß bei Bedampfungsprozessen, bei denen ein Gas in die Vakuumkammer eingelassen wird, mit dem aus der Rückstoßkraft gewonnenen Signal der Gasfluß so geregelt wird, daß die Rückstoßkraft konstant gehalten wird.

## Claims

1. Method for controlling a vacuum vaporisation process with which substrates are vacuum coated by at least one vaporiser, preferably heated by electron beams, said vaporiser being arranged in a vacuum chamber, and at least one process parameter is adapted to the vaporising conditions via a control circuit, **characterised in that** the repulsion force of the vaporising current, which is directed onto the substrates to be vacuum coated and operates perpendicularly to the surface of the item to be vacuum coated, is determined at least at one point, the force operating on the attachment of the vaporiser being measured, in that this obtained measured variable is detected as a signal, and in that this signal is supplied as a control variable to the control circuit which controls the process parameters.

2. Method according to claim 1, **characterised in that** in the vaporiser, which is arranged in the vacuum chamber in a position diverging from the vertical, the repulsion force is detected in such a manner that the weight and repulsion force operating on the vaporiser are measured as a sum, in that the repulsion force is separated from the sum of these two forces using measuring technology, at least one process parameter which determines the vaporising rate being changed in size so quickly that the alteration rate of the repulsion force is large relative to the alteration rate of the weight, and in that by subtraction of the sum of these forces of the process parameters determining the vaporising rate before alteration and the sum of these forces after alteration, the repulsion force is determined.

3. Method according to claim 2, **characterised in that** the alteration of a process parameter determining the vaporisation rate is effected such that the supply of energy to the item to be vacuum coated is temporarily interrupted or reduced, or the power density of the energy on the item to be vacuum coated is reduced.

4. Method according to claim 1 to 3, **characterised in that** by means of the signal obtained from the repulsion force the control of the energy supply to the item to be vacuum coated is effected such that the repulsion force is kept constant.

5. Method according to claim 1 to 4, **characterised in that** when using vaporisers with refill devices for the item to be vacuum coated, the filling height of the vaporiser is kept constant by control of the filling quantity with the signal obtained from the repulsion force.

6. Method according to claim 1 to 5, **characterised in that** by means of the signal obtained from the repulsion force for controlling the local and/or temporal distribution of the power density on the item to be vacuum coated, the repulsion force is set to a prescribed reference value.

7. Method according to claim 1 to 6, **characterised in that** the repulsion force in large-surface vaporisers is determined at least at two points, and the local and/or temporal distribution of the power density on the item to be vacuum coated is adjusted such that the individual repulsion forces are set to prescribed reference values.

8. Method according to claim 1 to 7, **characterised in that** in vaporisation processes in which a gas is introduced into the vacuum chamber, the gas flow is adjusted by the signal obtained from the repulsion force such that the repulsion force is kept constant.

## Revendications

1. Procédé de régulation d'un processus de métallisation sous vide, à l'aide duquel, à partir d'au moins un évaporateur, de préférence chauffé par un rayonnement d'électrons, disposé dans une chambre à vide, on procède à la métallisation de substrats et au moins un paramètre du processus étant adapté aux conditions de métallisation par l'intermédiaire d'un circuit de régulation,
caractérisé en ce que
- la force de réaction du courant de vapeur dirigé sur le substrat à métalliser, qui agit perpendiculairement par rapport à la surface du produit à métalliser, est déterminée en au moins un emplacement auquel la force, agissant sur la fixation de l'évaporateur, est mesurée,
- cette grandeur de mesure obtenue est appréhendée à titre de signal, et
- ce signal est amené, à titre de grandeur de régulation, au circuit de régulation qui régule les paramètres de processus.

2. Procédé selon la revendication 1,
caractérisé en ce que
- lorsque l'évaporateur est disposé dans la chambre à vide en une position différente de la position verticale, la force de réaction est déterminée de manière que la force due au poids et la force de réaction, agissant sur l'évaporateur, soient mesurées sous la forme d'une somme,
- à partir de la somme de ces deux forces, on isole par une technique de mesure la force de réaction,
- au moins un paramètre de processus déterminant la vitesse de métallisation est modifié en ampleur avec une rapidité telle que la vitesse de variation de la force de réaction soit grande par rapport à la vitesse de variation de la force due au poids, et
- on détermine la force de réaction, en formant la différence de la somme de ces forces avant la modification et la somme de ces forces après la modification des paramètres de processus déterminant la vitesse de métallisation.

3. Procédé selon la revendication 2,
caractérisé en ce que
la modification d'un paramètre de processus déterminant la vitesse de métallisation s'effectue de manière que l'apport d'énergie au produit de métallisation est brièvement interrompu ou réduit, ou que la densité de puissance de l'énergie sur le produit de métallisation est réduite.

4. Procédé selon les revendications 1 à 3,
caractérisé en ce qu'
avec le signal obtenu à partir de la force de réaction, on effectue la régulation de l'apport d'énergie au produit de métallisation, de manière que la force de réaction soit maintenue à une valeur constante.

5. Procédé selon les revendications 1 à 4,
caractérisé en ce qu'
en cas d'utilisation d'évaporateurs équipés de dispositifs de rechargement pour le produit de métallisation, avec le signal obtenu à partir de la force de réaction on maintient à une valeur constante la hauteur de remplissage de l'évaporateur, par une régulation de la quantité de remplissage.

6. Procédé selon les revendications 1 à 5,
caractérisé en ce qu'
avec le signal obtenu à partir de la force de réaction, on régule la force de réaction à une valeur de consigne prédéterminée, pour réguler la répartition locale et/ou temporelle de la densité de puissance sur le produit de métallisation.

7. Procédé selon les revendications 1 à 6,
caractérisé en ce que
- pour des évaporateurs de grandes surfaces, la force de réaction est déterminée en au moins deux emplacements, et
- la distribution locale et/ou temporelle de la densité de puissance sur le produit de métallisation est régulée de manière que les différentes forces de réaction soient réglées à des valeurs de consigne prédéterminées.

8. Procédé selon les revendications 1 à 7,
caractérisé en ce qu'
en cas de processus de métallisation pour lesquels on introduit un gaz dans la chambre à vide, avec le signal obtenu à partir de la force de réaction, on régule le flux de gaz de manière que la force de réaction soit maintenue constante.
